# EUROPEAN PATENT SPECIFICATION

(11) **EP 2 619 377 B1**
(45) Date of publication and mention of the grant of the patent: **07.01.2015**
(21) Application number: 11797347.9
(22) Date of filing: 26.09.2011
(51) Int. Cl.: E04B 1/76, E04B 2/92, E04F 13/08

(54) **SELF-SUPPORTING MODULE FOR THE FACADE OF A BUILDING**
SELBSTTRAGENDES MODUL FÜR DIE FASSADE EINES GEBÄUDES
MODULE AUTOPORTANT POUR LA FAÇADE D'UN BÂTIMENT

(30) Priority: 24.09.2010 IT BO20100575
(43) Date of publication of application: 31.07.2013
(73) Proprietor: Pro Energy Systems S.r.l., Ascoli Piceno (IT)
(72) Inventor: FICCADENTI, Marco, Ascoli Piceno (IT); LEUZZI, Angela Giovanna, Ascoli Piceno (IT); MARCHETTI, Alessandra, Ascoli Piceno (IT); MORRESI, Lorenzo, Ascoli Piceno (IT); MURRI, Roberto, Ascoli Piceno (IT); OTTONE, Maria Federica, Ascoli Piceno (IT); PINTO, Nicola, Ascoli Piceno (IT); TASCINI, Simone, IAscoli Piceno (IT)
(74) Representative: Boggio, Luigi
(86) International application number: PCT/IB2011/054224
(87) International publication number: WO 2012/038941

(56) References cited:
- WO-A1-2008/069764
- DE-A1- 4 004 103
- DE-U1- 8 806 696
- DE-U1- 20 014 707
- US-A- 4 114 334

## Description

### TECHNICAL FIELD

The present invention relates to a self-supporting module used in the building sector, in particular for providing a continuous façade.

### BACKGROUND ART

As is known, a continuous façade is a type of continuous external enveloping structure for buildings, which comprises modular elements that can be set on top of one another, which are connected to a load-bearing structure of the building itself.

Self-supporting modules of a known type are, however, characterized by diffusion of vapour due to infiltration of air.

A known self supporting module is disclosed in US-A-4 114 334.

### DISCLOSURE OF INVENTION

The aim of the present invention is consequently to provide a self-supporting module that will enable the disadvantage of the known art to be overcome.

According to the present invention a self-supporting module is provided according to what is claimed in Claim 1 and, preferably, in any one of the subsequent claims that depend directly or indirectly upon Claim 1.

### BRIEF DESCRIPTION OF THE DRAWINGS

The present invention will now be described with reference to the annexed drawings, which illustrate some non-limiting examples of embodiment thereof and in which:
- Figure 1 is a perspective view in side elevation of a preferred embodiment of a self-supporting module of the present invention;
- Figure 2 is a plan view of the module of Figure 1;
- Figure 3 is a cross-sectional view along the line III-III of the module of Figure 2;
- Figure 4 is an exploded perspective view of a first embodiment of a detail of Figure 1;
- Figure 5 is an exploded perspective view of a second embodiment of the detail of Figure 1;
- Figures 6a to 6e illustrate in sequence the steps of a process of assembly of the module of Figure 1; and
- Figure 7 illustrates a portion of a façade of a building obtained by setting a plurality of modules of Figure 1 on top of one another.

### BEST MODE FOR CARRYING OUT THE INVENTION

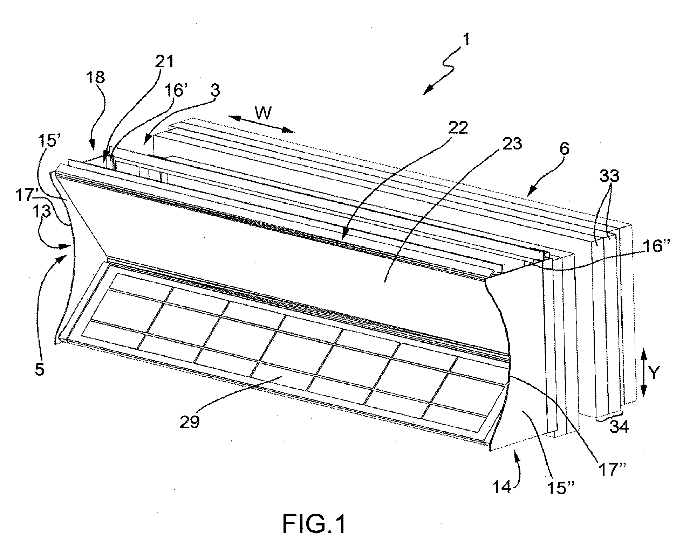

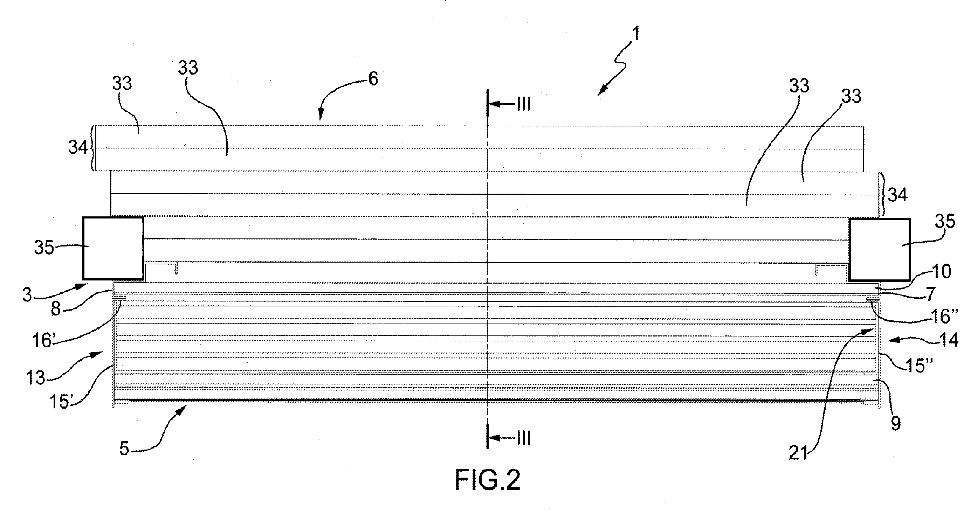

In Figures 1 to 7, designated as a whole by 1 is a self-supporting module used in the building sector, and in particular for the construction of a continuous façade 2.

The module 1 has as a whole a substantially polyhedral shape, preferably parallelepipedal. The module comprises a load-bearing structure 18 for connection with further modules 1 and/or with a load-bearing ensemble 4 of the façade 2, an external finishing assembly 5, and an insulation packet 6.

The load-bearing structure 18 is made of a suitable material, preferably aluminium, and is defined by a plurality of uprights with a development both in a horizontal direction and in a vertical direction and by flanges that are assembled in succession to obtain the final configuration.

In particular, the load-bearing structure 18 comprises a supporting frame 3, which constitutes the rear part of the load-bearing structure 18. The supporting frame 3 comprises a right-hand upright 7 and a left-hand upright 8, both of which have a vertical development; according to a preferred variant, the two uprights 7 and 8 have in cross section substantially specular shapes. The two uprights 7 and 8 have in section a profile designed to enable coupling with further elements of the load-bearing structure 18 of the module 1 and of the load-bearing ensemble 4 of the façade 2.

The supporting frame 3 then comprises two uprights, designated respectively by 10 and 12, which have a horizontal development, have in section a different profile, and define respectively the rear top upright 10, and the rear bottom upright 12, which have sections designed to perform the functions of strengthening and connection.

The load-bearing structure 18 then comprises two flanges 13 and 14 that define the side walls, which are also load-bearing and have the function of containment of the module 1. The two flanges 13 and 14 are specular to one another and each comprise a respective side wall 15' and 15" and a respective rear connection wall 16' and 16". Each rear wall 16', 16" is designed to enable coupling of the respective flange 13 and 14 to the right-hand vertical upright 7 and with the left-hand vertical upright 8, respectively. Each side wall 15', 15" has a curvilinear notch 17', and 17". According to a preferred variant, the flange 13 and the upright 8 constitute a single element, as likewise the flange 14 and the upright 7. The supporting frame 18 then comprises two uprights 9 and 11 with horizontal development, which have in section a different profile. According to a preferred variant, the uprights 9 and 11 define, respectively, the front top upright 9, having in section a profile specular to the upright 10, and the front bottom upright 11, having in section a profile specular to the upright 12. The upright profiles designated by 9, 10, 11 and 12 connect and strengthen structurally the flanges 13 and 14; they moreover identify the seats for coupling with further modules 1.

Coupling between the uprights 7 and 8 with vertical development, which are specular to one another, and the uprights 9, 10, 11, 12 with horizontal development and with the flanges 13 and 14 is obtained by appropriate fixing means, such as, for example, rivets or bolts and interlocking joints previously defined during production of the individual components.

Hence, the coupling of the supporting frame 3 with the flanges 13 and 14, and finally with the uprights 9 and 11, constitutes the load-bearing structure 18 of the entire module 1.

Connected to said load-bearing structure 18 are two elements 19 and 20 that define the external visible portion of the finishing assembly 5. The two elements 19 and 20 are inclined with respect to one another to form an angle α that can vary on the basis of the latitude of exposure and of the format of the module 1, and that in any case has an amplitude ranging between 90° and 135°.

The angles envisaged enable the module 1 to have a wide range of geometrical configurations designed to obtain efficient exposure both in the Northern hemisphere and in the Southern hemisphere.

Defined between the uprights (designated by the reference numbers 7 to 12) of the load-bearing structure 18 is a gap 21. The gap 21 has a variable width and is in any case not less than 3 cm. The gap 21 is sized so as to enable passage of a flow of air for ventilation of the external finishing assembly 5.

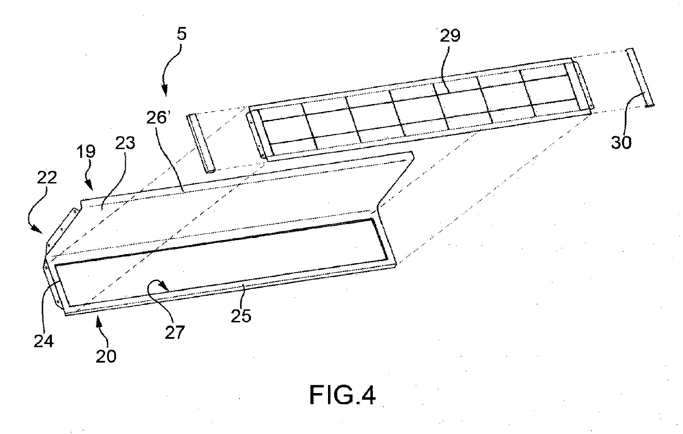

According to a first embodiment illustrated in Figure 4, the external finishing assembly 5 comprises a support 22 defined by a top element 19 and a bottom element 20, which are inclined with respect to one another by the angle α. The top element 19 is constituted by a wall 23, the inner surface of which (not exposed) is ribbed to bestow stiffness on the element, while an outer surface (exposed) is decorated or variously painted. The bottom element 20 is constituted by a wall 24.

The support 22 is made of a single piece. The bottom element 20 is perforated at the centre to form a frame 25 that delimits a through hole 27 of considerable dimensions. The frame 25 functions as resting and connection element for a top element 29. According to a preferred variant, the top element 29 comprises a string of photovoltaic cells and is provided with elements 30 for closing the electrical circuits. According to further variants (not illustrated), the top element 29 can comprise a solar thermal panel for the production of hot sanitary water, or a combined panel for the production of electrical energy from photovoltaic sources and hot water from solar thermal sources, said panels being also provided with adequate connections.

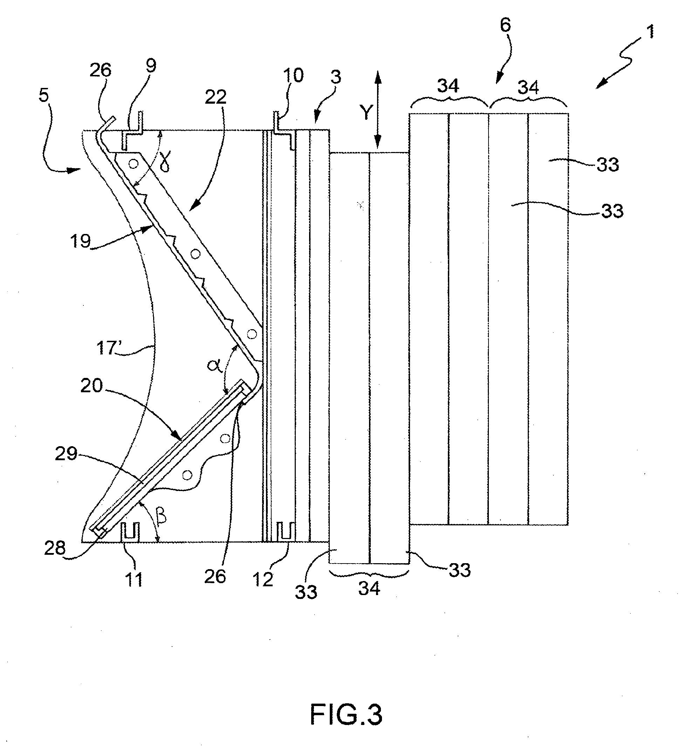

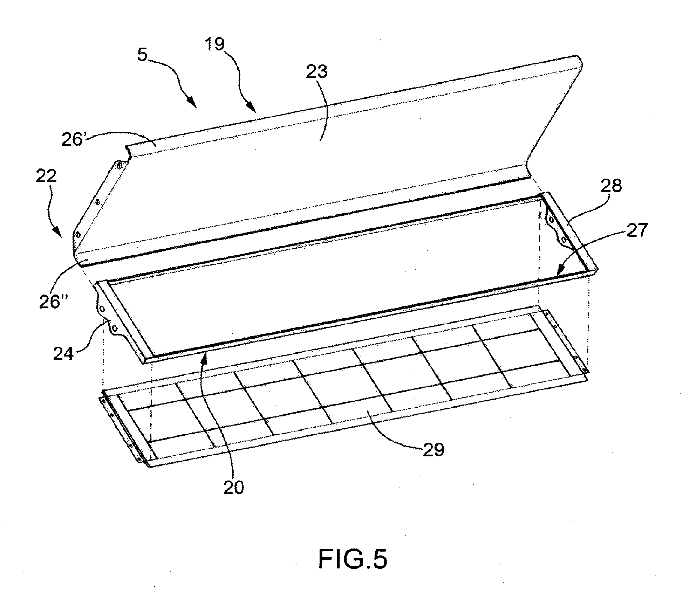

According to a further and preferred variant illustrated in Figure 5, the support 22 is defined by just the top element 19, constituted by the top wall 23 and by a pair of jointing portions of wall, a top one 26' and a bottom one 26''. In particular, a top portion 26' of wall has the function of jointing between the top element 19 and the element 24 of a new overlying panel 1, during assembly of the façade of the building, whereas a bottom portion 26'' of wall has the function of jointing between the top element 19 and the bottom element 24 of one and the same panel 1. Figure 3 shows in cross-sectional view the jointing between the portion 26 and the bottom element 24, and an appendage of the portion 26 that comes out and extends upwards, with respect to the height of the flanges 13 and 14 in order to create a rest for the components of an overlying panel 1.

According to a variant, the upright 9 is made of a single piece with the top portion 26'.

Instead, the bottom element 24 is constituted by a frame 28, which is provided for lateral anchorage to the flanges 13 and 14, and coupled to which is the top element 29 (i.e., the string of photovoltaic cells or the solar thermal panel).

The anchorage frame 28 is designed to support the top element 29, which is in turn provided for capturing the incident solar radiation. The module 1 is then provided with appropriate connection systems for producing electrical energy and/or hot sanitary water by capturing solar radiation. In order to improve the efficiency of the top element 29, according to a preferred variant, the outer (or exposed) surface of each top wall 23 facing the top element 29 is coated on the outside with a highly reflecting material in such a way as to increase the incident solar radiation.

The top element 29 is inclined by an angle β with respect to a horizontal plane.

The angle β is such as to enable a good performance of the module 1 in terms of capture of solar radiation.

The top wall 23 is in turn inclined by an angle γ with respect to a horizontal plane. The angle γ is such as to enable the top wall not to shade during the day the surface of the top element 29 exposed to solar radiation.

The bottom wall 24, the top wall 23 and, possibly, the top element 29 perform the function of closing the module 1 at the front. The inclination of the bottom wall 24 and of the top wall 23 bestows on the module 1 a particular undulated optical effect and is such as to enable maximization of the overall capture of solar energy (i.e., both incident light and reflected light).

According to a preferred variant, the outer (exposed) surface of each top wall 23 is coated on the outside with decorating material (for example, with a coloured pattern or else a geometrical pattern) and is conceived for bestowing an ornamental graphic texture on the module 1 and on the facade 2 as a whole.

The gap 21 is sized so as to trigger a convective motion of the air heated by the incident solar radiation on the bottom element 20. According to the embodiment illustrated in Figure 4, the through hole 27 is designed to improve aeration of the top element 29.

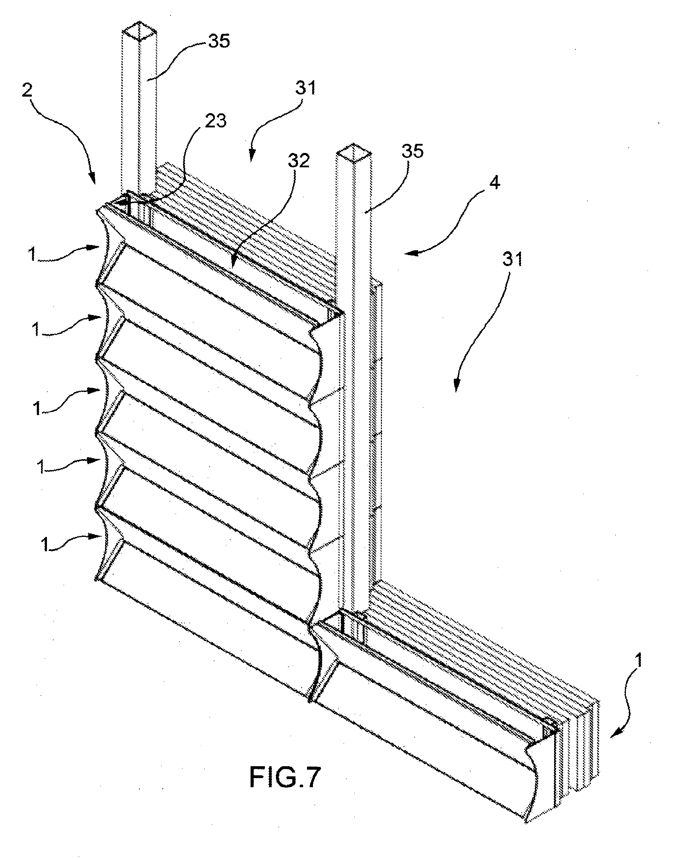

According to what is illustrated in Figure 7, in the case of a continuous facade 2 obtained by setting a plurality of self-supporting modules 1 on top of one another, the continuous façade 2 is divided into a plurality of columns 31 each of which is provided with a circuit 32 for forced circulation of air. Within each column 31, the gaps 21 of the respective modules 1 are in communication both with the gaps 21 of the adjacent modules 1, by means of the holes provided on the flanges 13 and 14 (inserted in which are also the systems of connection between the various elements 29) and with the gaps 21 of the modules 1 set above and below to enable circulation of the air inside the column 31. The circuit 32 of each column 31 is defined by the gaps 21 of the respective modules 1 and by a duct for inlet (not illustrated) and a duct for outlet (not illustrated) of air. The ducts for inlet and outlet of air are set at respective ends of the column 31 (i.e., at the base and at the top) to enable inlet and outlet of the external air.

Finally, the module 1 comprises at the rear the insulation packet 6. The packet 6 is made up of a plurality of layers 33, which are each made of an insulating material and which have thermal capacities that differ from one another. According to a preferred variant, the packet 6 comprises at least one layer 33* of a material of organic origin (for example, mineralized wood wool), which alternates with at least one layer 33** of synthetic material (for example, EPS or foamed polystyrene with a graphite-based additive). The first type of layer 33* is characterized by a high thermal capacity and by good mechanical characteristics, whereas the second type of layer 33** is characterized by a high thermal resistance. In particular, the insulation packet 6 comprises six layers 33* of synthetic material alternating with seven layers 33** of material of organic origin (thirteen layers 33 in all). The layers 33* of synthetic material are preferably made of EPS and graphite. Each of the layers 33* of synthetic material is coupled, at a front surface and a rear surface, to an outer surface of a layer 33** preferably of mineralized wood wool.

The layers 33 are coupled in twos. Each pair 34 is staggered with respect to the adjacent pairs 34 of layers 33. According to a preferred variant each pair 34 of layers 33 is staggered with respect to the two adjacent pairs 34 both in a horizontal direction W and in a vertical direction Y according to what is illustrated in Figures 1 and 3. It has been noted that in this way, the insulation packet 6 enables reduction of the thermal bridges, of the losses of heat, and of the diffusion of vapour due to infiltration of air. According to further variants, each pair 34 is staggered with respect to the two adjacent pairs 34 in a preferred direction (either horizontal or vertical). According to further variants, each pair 34 is staggered with respect to the two adjacent pairs 34 in opposite directions.

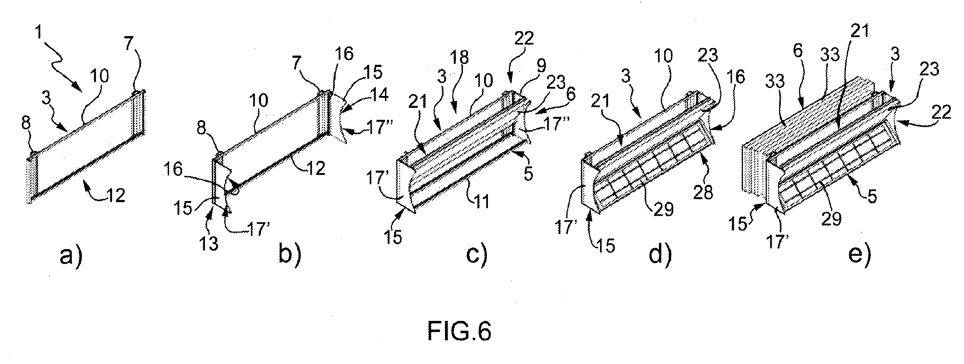

Figures 6 and 7 illustrate in sequence the various steps of the process of assembly of the module 1.

The process envisages a first step of assembly of the load-bearing structure 18, said step in turn comprising the following steps:
- coupling the uprights 7 and 8 with vertical development to the rear (top 10 and bottom 12) uprights with horizontal development;
- coupling the side flanges 13 and 14 to the uprights 7 and 8 with vertical development;
- coupling the front (top 9 and bottom 11) uprights with horizontal development.

Subsequently, the load-bearing structure 18 is connected to the external finishing assembly 5, in particular to the wall 23 and, in a subsequent step, if this is envisaged, to the anchorage frame 28 and to the top element 29. Finally, the ensemble formed by the load-bearing structure 18 and the external finishing assembly 5 is coupled to the insulation packet 6 (already pre-assembled in a preliminary step).

Figure 7 illustrates the façade 2 of a building obtained by setting a series of modules 1 on top of one another. The modules 1 are coupled to the load-bearing ensemble 4 of the building comprising a plurality of vertical pillars 35 made of steel, which are anchored at their ends by means of appropriate fixing elements (for example, flanges) for fixing to horizontal transoms (not illustrated) of the building.

The pillars 35 are set at a distance from one another that is equal to the width of the module 1, and each pair of adjacent pillars 35 defines a column 31. The individual modules 1 are stacked dry one at a time inside the space available between two adjacent pillars 35 and are coupled, with appropriate fixing means provided, to the pillars 35 themselves, enabling the appropriate connections between the top elements 29 of the modules 1.

According to a preferred variant, the load-bearing ensemble 4 of the façade 2 also comprises a plurality of horizontal transoms (not illustrated), which are set at a given distance from one another, are designed to connect two adjacent pillars 35, and have the function of providing an intermediate supporting element for the vertical load of the column 31 or of strengthening the load-bearing ensemble 4. In this way, each module 1 is designed to withstand the vertical load of the respective column 31 that derives from the weight of the overlying modules 1 up to the first horizontal transom.

According to a preferred variant, it is possible to differentiate the facades 2 of a building. In particular, it is possible to provide just the modules 1 of the façade 2 with the top elements 29 for direct capture of the solar radiation in order to contain the costs of production of the façade 2 itself.

The module 1 described herein presents the advantage of enabling a reduction of the labour costs for construction of the façade 2 and affording, at the same time, excellent thermal insulation and excellent performance in terms of energy (in the embodiment where insertion of the top element 29 is envisaged).

The module 1 described herein may be applied to load-bearing structures of any type of building by means of appropriate systems of connection of the pillars 35.

## Claims

1. A self-supporting module (1) for the façade (2) of a building provided with its own load-bearing structure (4), the module (1) comprises:
an external finishing assembly (5), which has a shaped structure and is suited to frontally close the module (1);
a frame (18), which can be coupled to the load-bearing structure (4) and to further self-supporting modules (1) and functions as support for the external finishing assembly (5), there being defined within the frame (18) a gap (21) designed to enable passage of a flow of air for aerating the external finishing assembly (5); and
an insulation packet (6), which is coupled to the frame (3) and comprises a plurality of layers (33) arranged in contact with one another and made of at least one first insulating material, **characterized in that** each layer (33) is arranged staggered with respect to the adjacent layers (33) in a first direction.

2. The module according to Claim 1, wherein the insulation packet (6) comprises at least one first layer (33*) made of a first material and at least one second layer (33**) made of a second material.

3. The module according to Claim 2, wherein the first layer (33*) is made of a material of organic origin and the second layer (33**) is made of a synthetic material.

4. The module according to Claim 2 or Claim 3, wherein the insulation packet (6) comprises a plurality of first layers (33*) and a plurality of second layers (33**) alternating one another.

5. The module according to any one of the preceding claims, wherein each layer (33, 33*, 33**) is set staggered with respect to the adjacent layers (33, 33*, 33**) in a second direction.

6. The module according to any one of the preceding claims, wherein the external finishing assembly (5) comprises a top wall (19) and a bottom portion (20); the top wall (19) and the bottom portion (20) are inclined with respect to one another in such a way as to form an angle (α), the amplitude of which is between 90° and 135°.

7. The module according to Claim 6, wherein the bottom portion (20) comprises at least one finishing element (29).

8. The module according to Claim 7, wherein the finishing element (29) comprises a string (29) of photovoltaic cells.

9. The module according to Claim 7 or Claim 8, wherein the finishing element (29) comprises a solar thermal panel for the production of hot sanitary water.

10. The module according to any of Claims 6 to 9, wherein the bottom portion comprises a bottom wall (24), which is jointed to the top wall (23).

11. The module according to Claim 10, wherein the bottom wall (24) supports the top finishing element (29) and has at least one through hole (27) to improve aeration of the top finishing element (29) itself.

12. The module according to any one of the preceding claims, wherein the frame (18) comprises two side elements (13,14), which are designed to close the module (1) laterally and have a curvilinear profile.

13. A façade (2) of a building comprising at least one module (1) provided according to one or more of the preceding claims.

## Patentansprüche

1. Selbsttragendes Modul (1) für die Fassade (2) eines Gebäudes, welches mit seiner eigenen lasttragenden Struktur (4) versehen ist, wobei das Modul (1) aufweist:
eine Außenverkleidungsanordnung (5), die eine geformte Struktur aufweist und zum Abschließen des Moduls (1) zur Vorderseite geeignet ist;
einen Rahmen (18), der mit der lasttragenden Struktur (4) und anderen selbsttragenden Modulen (1) verbindbar ist und als Stütze für die Außenverkleidungsanordnung (5) dient, wobei in dem Rahmen (18) ein Spalt (21) definiert ist, welcher derart ausgebildet ist, dass er den Durchtritt eines Luftstroms zum Belüften der Außenverkleidungsanordnung (5) ermöglicht; und
ein Isolierpaket (6), das mit dem Rahmen (3) verbunden ist und mehrere Schichten (33) aufweist, die aneinander anliegend angeordnet sind und aus mindestens einem ersten Isoliermaterial hergestellt sind, **dadurch gekennzeichnet, dass** jede Schicht (33) in Bezug auf die benachbarten Schichten (33) in eine erste Richtung versetzt ist.

2. Modul nach Anspruch 1, bei welchem das Isolierpaket (6) mindestens eine erste Schicht (33*) aus einem ersten Material und mindestens eine zweite Schicht (33**) aus einem zweiten Material aufweist.

3. Modul nach Anspruch 2, bei welchem die erste Schicht (33*) aus einem Material organischen Ursprungs hergestellt ist und die zweite Schicht (33**) aus einem synthetischen Material hergestellt ist.

4. Modul nach Anspruch 2 oder Anspruch 3, bei welchem das Isolierpaket (6) mehrere erste Schichten (33*) und mehrere zweite Schichten (33**) aufweist, die sich abwechseln.

5. Modul nach einem der vorhergehenden Ansprüche, bei welchem jede Schicht (33, 33*, 33**) in Bezug auf die benachbarten Schichten (33, 33*, 33**) in eine zweite Richtung versetzt ist.

6. Modul nach einem der vorhergehenden Ansprüche, bei welchem die Außenverkleidungsanordnung (5) eine obere Wand (19) und einen unteren Bereich (20) aufweist; die obere Wand (19) und der untere Bereich (20) sind in Bezug zueinander derart geneigt, dass sie einen Winkel (α) bildet, dessen Amplitude zwischen 90° und 135° liegt.

7. Modul nach Anspruch 6, bei welchem der untere Bereich (20) mindestens ein Verkleidungselement (29) aufweist.

8. Modul nach Anspruch 7, bei welchem das Verkleidungselement (29) eine Reihe (29) photovoltaischer Zellen aufweist.

9. Modul nach Anspruch 7 oder Anspruch 8, bei welchem das Verkleidungselement (29) ein solarthermisches Panel zur Erzeugung von Warmwasser aufweist.

10. Modul nach einem der Ansprüche 6 bis 9, bei welchem der untere Bereich eine Bodenwand (24) aufweist, die mit der oberen Wand (23) verbunden ist.

11. Modul nach Anspruch 10, bei welchem die Bodenwand (24) das obere Verkleidungselement (29) stützt und mindestens ein Durchgangsloch (27) aufweist, um die Belüftung des oberen Verkleidungselements (29) selbst zu verbessern.

12. Modul nach einem der vorhergehenden Ansprüche, bei welchem der Rahmen (18) zwei Seitenelemente (13, 14) aufweist, die zum seitlichen Schließen der Module (1) ausgebildet sind und ein gebogenes Profil aufweisen.

13. Fassade (2) eines Gebäudes mit mindestens einem Modul (1) nach einem oder mehreren der vorhergehenden Ansprüche.

## Revendications

1. Module auto-supporté (1) pour la façade (2) d'un bâtiment muni de sa propre structure porteuse (4), le module (1) comprenant :
un ensemble de finition externe (5), qui comporte une structure conformée et qui est approprié pour fermer frontalement le module (1) ;
un bâti (18), qui peut être couplé à la structure porteuse (4) et à d'autres modules auto-supportés (1) et qui joue le rôle de support pour l'ensemble de finition externe (5),
un espace (21) étant défini à l'intérieur du bâti (18), conçu pour permettre le passage d'un écoulement d'air pour aérer l'ensemble de finition externe (5) ; et
un paquet d'isolation (6), qui est couplé au bâti (3) et qui comprend une pluralité de couches (33) disposées en contact les unes avec les autres et constituées par au moins un premier matériau d'isolation, **caractérisé en ce que** chaque couche (33) est disposée de façon étagée par rapport aux couches adjacentes (33) dans une première direction.

2. Module selon la revendication 1, dans lequel le paquet d'isolation (6) comprend au moins une première couche (33 *) réalisée en un premier matériau et au moins une deuxième couche (33**) réalisée en un deuxième matériau.

3. Module selon la revendication 2, dans lequel la première couche (33*) est réalisée en un matériau d'origine organique et la deuxième couche (33**) est réalisée en un matériau synthétique.

4. Module selon la revendication 2 ou la revendication 3, dans lequel le paquet d'isolation (6) comprend une pluralité de premières couches (33*) et une pluralité de deuxièmes couches (33**) alternant les unes avec les autres.

5. Module selon l'une quelconque des revendications précédentes, dans lequel chaque couche (33, 33*, 33**) est disposée de façon étagée par rapport aux couches adjacentes (33, 33*, 33**) dans une deuxième direction.

6. Module selon l'une quelconque des revendications précédentes, dans lequel l'ensemble de finition externe (5) comprend une paroi supérieure (19) et une partie inférieure (20) ; la paroi supérieure (19) et la partie inférieure (20) étant inclinées l'une par rapport à l'autre de façon à former un angle (α) dont l'amplitude est comprise entre 90° et 135°.

7. Module selon la revendication 6, dans lequel la partie inférieure (20) comprend au moins un élément de finition (29).

8. Module selon la revendication 7, dans lequel l'élément de finition (29) comprend une chaîne (29) de cellules photovoltaïques.

9. Module selon la revendication 7 ou la revendication 8, dans lequel l'élément de finition (29) comprend un panneau thermique solaire pour la production d'eau chaude sanitaire.

10. Module selon l'une quelconque des revendications 6 à 9, dans lequel la partie inférieure comprend une paroi inférieure (24), qui est réunie à la paroi supérieure (23).

11. Module selon la revendication 10, dans lequel la paroi inférieure (24) supporte l'élément de finition supérieur (29), et comporte au moins un trou traversant (27) de façon à améliorer l'aération de l'élément de finition supérieur (29) lui-même.

12. Module selon l'une quelconque des revendications précédentes, dans lequel le bâti (18) comprend deux éléments latéraux (13, 14), qui sont conçus de façon à fermer le module (1) de façon latérale, et qui ont un profil curviligne.

13. Façade (2) d'un bâtiment, comprenant au moins un module (1) réalisé selon l'une ou plusieurs des revendications précédentes.
